# EUROPEAN PATENT APPLICATION

(11) **EP 1 431 829 A1**
(43) Date of publication of application: **23.06.2004**
(21) Application number: 03257969.0
(22) Date of filing: 17.12.2003
(51) Int. Cl.: G03F 7/20

(54) **Lithographic projection apparatus**

(30) Priority: 19.12.2002 EP 02080451
(71) Applicant: ASML Netherlands B.V., 5503 LA Veldhoven (NL)
(72) Inventor: Ottens, Joost Jeroen, 5508 TR Veldhoven (NL); van Kervinck, Marcel Nicolaas Jacobus, 5611 PC Eindhoven (NL)
(74) Representative: Leeming, John Gerard

(57) **Abstract**

During scanned exposure of target portions at the edge of the substrate, the position of an edge of the illumination field is changed so as to prevent or reduce radiation falling onto the substrate table or to expose an L-shaped area. In this way the heat load on the substrate table can be reduced and dummy structures can fill a mouse bite (14) without overlapping an alignment mark (P2).

## Description

The present invention relates to a device manufacturing method, a devicce manufactured thereby, a computer program for controlling a lithographic apparatus and a lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

When exposing a plurality of rectangular dies on a circular (except for the flat, if provided) substrate, it will be appreciated that not all of the substrate can be filled with whole dies; around the edges so-called mouse bites would be left unexposed. To ensure uniformity in subsequent processing, it is customary to perform exposures of dummy structures in the areas where complete dies cannot be fitted. The purpose is that complete dies near the edge of the substrate have neighborhoods that appear similar to the neighborhoods of dies in the center of the substrate and thus their subsequent processing is more similar. Otherwise, no structures would build up on the unexposed areas and the unexposed areas would remain smooth and after several process layers would be at a different level than the exposed areas. This can lead to undesirable effects such as variations in resist thickness at the edges, since the resist runs off more easily over the smooth unexposed areas, incorrect level measurements and/or undesirably abrupt leveling movements during a scan. It can also be desirable to expose dies that overlap the edge of the substrate if the mask contains more than one device and a whole device or devices, but not the whole mask image, can be accommodated by an edge die. The additional devices that are made in this way increase yield.

However, if exposures that overlap the edge of the substrate are carried out, the projection beam will fall on the substrate table leading to undesirable heating thereof. The substrate table will in general carry mirrors for the interferometric displacement measuring system (for which reason it is often referred to as the mirror block) which measures movements of the substrate table and these mirrors must be maintained flat to a very high degree of accuracy. Localized heating of the substrate table leading to thermal expansion can distort the mirrors and cause errors in the measurement of the position of the substrate table, leading to overlay errors in exposures. US 6,232,051 and US 5,331, 371 disclose the use of masking blades in step and repeat type lithographic apparatus to prevent unwanted radiation from falling on the substrate table during the exposure of edge dies but do not suggest how the problem may be overcome in a scanned exposure.

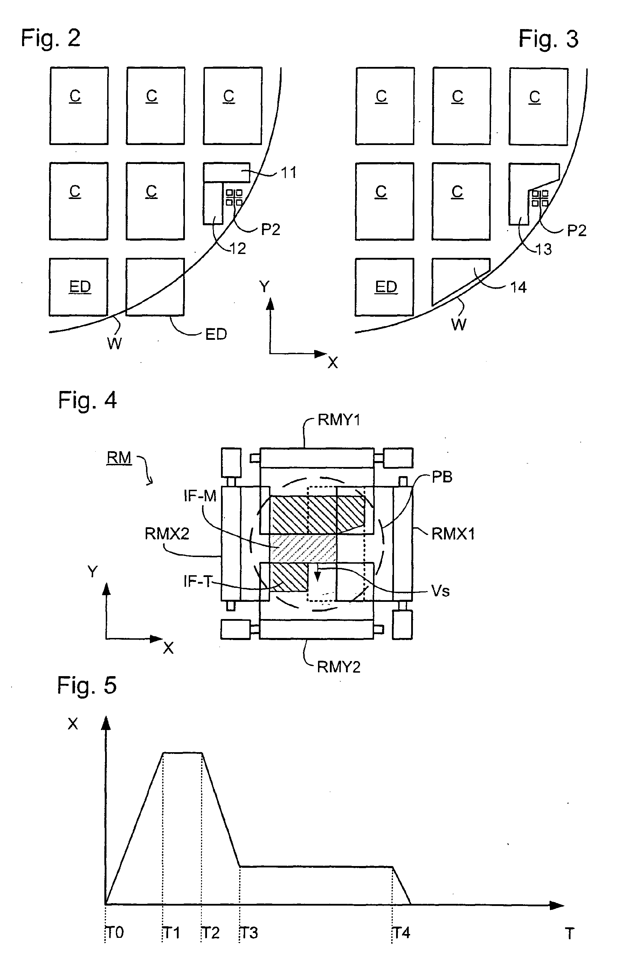

Also, in some cases, alignment marks may be located in the mouse bites and these must be protected from subsequent exposures. As shown in Figure 2 of the accompanying drawings, to expose dummy structures in the part of the mouse bite not occupied by the alignment marker P2 whilst not exposing the alignment marker, requires the performance of two exposure 11,12 to expose an L-shaped area on the substrate bordering the whole dies C but not covering the alignment marker P2. The necessity to perform two exposures is an undesirable loss of throughput. US 5,760,881 discloses shields at substrate level that can be moved over the substrate to protect alignment marks.

It is an object of the present invention to provide a method of exposing structures on a substrate in a non-rectangular area, for example around an area to be protected, in a shorter period of time.

According to an aspect of the invention, there is provided a device manufacturing method comprising:
- providing a substrate;
- providing a projection beam of radiation using an illumination system, the cross-section of said projection beam in an object plane being defined by a beam masking device;
- using patterning means at said object plane to impart the projection beam with a pattern in its cross-section; and
- projecting the patterned beam of radiation onto a target portion of the substrate whilst scanning said substrate in a scan direction; characterized by:
   changing the position of an edge of said cross-section of said projection beam in a direction perpendicular to said scanning direction during said projecting step.

By changing the position of an edge of the projection beam in the direction (X) perpendicular to the scanning direction (Y) during a scanned exposure, it is possible to expose an approximately L-shaped area in a single exposure step, which can be performed more quickly than two separate exposure steps because of the reduced overhead in repositioning the substrate for the second exposure. Dummy structures can be created around, but not overlapping, an area to be protected, such as an alignment mark. Also, dummy structures more completely filling a "mouse bite" can be created.

Changing the position of an edge of the projection beam in the X-direction would not normally be contemplated because the area exposed during the part of the scan during which the edge moves would exhibit a gradual change of dose. Thus structures in the transitional region will not be exposed properly and will likely tail off unpredictably rather than terminating cleanly. This, however does not matter when the structures being exposed are dummy structures rather than parts of complete dies - the structures will still perform their task of making the neighborhood of dies at the edge of the substrate more similar to those of dies in the middle.

The method of the invention can also be used to expose useful structures where the whole exposure field contains multiple devices and one or more devices can be accommodated in the irregularly shaped exposure, away from the transition area where the dose is non-uniform. Further, the invention can be used at the edge of the substrate even when there is no marker to protect. An irregularly shaped area that more closely fits onto the substrate can be exposed whilst avoiding exposure radiation being incident on the substrate table, thereby protecting the table and reducing stray light that might undesirably expose parts of the substrate.

Of course the width of the beam can be increased or decreased during the scan, depending on whether the scan begins at the "top" or "bottom" of the L-shape.

The present invention further provides a computer program for controlling a lithographic apparatus to manufacture devices, the program comprising program code means that, when executed by the control system of said lithographic apparatus, instruct the lithographic apparatus to:
- provide a projection beam of radiation using an illumination system, the cross-section of said projection beam in an object plane being defined by a beam masking device;
- use patterning means at said object plane to impart the projection beam with a pattern in its cross-section; and
- project the patterned beam of radiation onto a target portion of the substrate whilst scanning said substrate in a scan direction; characterized by code means to instruct the apparatus to:
   - change the position of an edge of said cross-section of said projection beam in a direction perpendicular to said scanning direction during said projecting step.

Such a computer program may be provided in a newly constructed apparatus or as an upgrade to an existing apparatus.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus which may be used to perform methods of the invention;
- Figure 2 depicts exposures around an alignment mark performed in a prior art method,
- Figure 3 depicts exposures around an alignment mark performed in a method of the invention;
- Figure 4 depicts a masking device used in performance of a method of the invention;
- Figure 5 is a graph of the position of a masking device over time in a method of the invention;
- Figure 6 depicts a lithographic projection apparatus according to a second embodiment of the invention;
- Figure 7 depicts a part of a substrate divided in substantially rectangular target portions;
- Figure 8 depicts a beam interceptor according to an embodiment of the invention;
- Figures 9a, 9b, 9c, 9d and 9e depict different modes of the beam interceptor;
- Figure 10 depicts a slit of light projected on a target portion; and
- Figure 11 depicts a third embodiment of the present invention.

### EMBODIMENTS

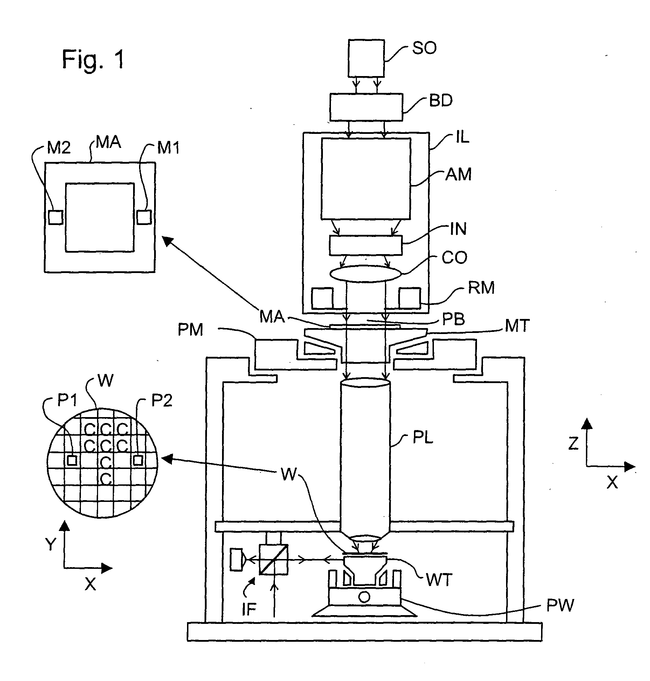

Figure 1 schematically depicts a lithographic apparatus which may be used to perform methods of the invention. The apparatus comprises:
- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

Included in the illuminator IL is a masking device RM which defines the area on the patterning means that is illuminated. The masking device may comprise four blades whose positions are controllable, e.g. by stepper motors, so that the cross-section of the beam may defined. It should be noted that the masking device need not be positioned proximate the patterning means but in general will be located in a plane that is imaged onto the patterning means (a conjugate plane of the patterning means). The open area of the masking means defines the area on the patterning means that is illuminated but may not be exactly the same as that area, e.g. if the intervening optics have a magnification different than 1.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure. The present invention is not used when the apparatus is used in this mode.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

As shown in Figure 2, in a conventional method, to print dummy structures in a mouse bite whilst protecting an alignment mark in that area, two exposures 11, 12 are necessary. This creates an L-shaped region of dummy structures. According to the invention, a single scanned exposure 13 is performed and during the scan, the width of the illumination field in the direction (X) perpendicular to the scanning direction (Y) is reduced so that an approximately L-shaped region is exposed, albeit with one inclined edge.

Figure 4 shows the masking device RM, which is used to accomplish this. The device consists of four blades; two blades RMY1, RMY2 project into the projection beam PB form the plus and minus Y directions respectively and two blades RMX1, RMX2 project into the beam from the plus and minus X directions respectively. During a scan, the Y blades RMY1, RMY2 move in the scan direction with velocity Vs, maintaining a constant separation so as to generate an elongate illumination field that sweeps across the patterning means. Depending on the optics between the masking device and the patterning means the illumination field may be curved, rather than rectangular and may be scaled relative to the open area of the masking device. This is conventional.

According to the invention, one or both of the X masking blades RMX1, RMX2 is moved during the scan so as that the width of the illumination field or its position in the X direction changes during the scan. In the example shown, masking blade RMX1 is in a retracted position at the beginning of a scan, time T1, and, at a certain point, time T2, is moved outwards to close down the illumination field for the narrow part of the L-shape. Having reached the necessary maximum extension, at time T3, the blade remains stationary until the end of the scan at T4. In Figure 4, the initial and final positions of the blade are shown in dashed line and an intermediate position is shown in solid. The area IF-T illuminated during the totality of the scan is shown in single diagonal hatching and the momentary illumination field IF-M is shown cross-hatched. Figure 5, is a graph of the width of the illumination field during the scan and include initial and final periods during which the illumination field is opened and closed.

It will also be appreciated that changing the width of the illumination field can be used to create areas of dummy patterns with inclined edges to more closely fill the mouse bites, as shown at 14 in Figure 3, whilst avoiding the projection beam spilling over the edge of the substrate. As shown in Figure 2, to provide structures in an irregularly shaped area the exposure is conventionally allowed to spill over the edge of the substrate. In this way the substrate table can be protected - it may contain components that might be damaged by the exposure radiation or by the concentrated heat load of the projection beam - and the generation of stray light can be reduced. Moving both blades, without necessarily changing the width of the illumination field, can be used to create diagonal regions of dummy structures.

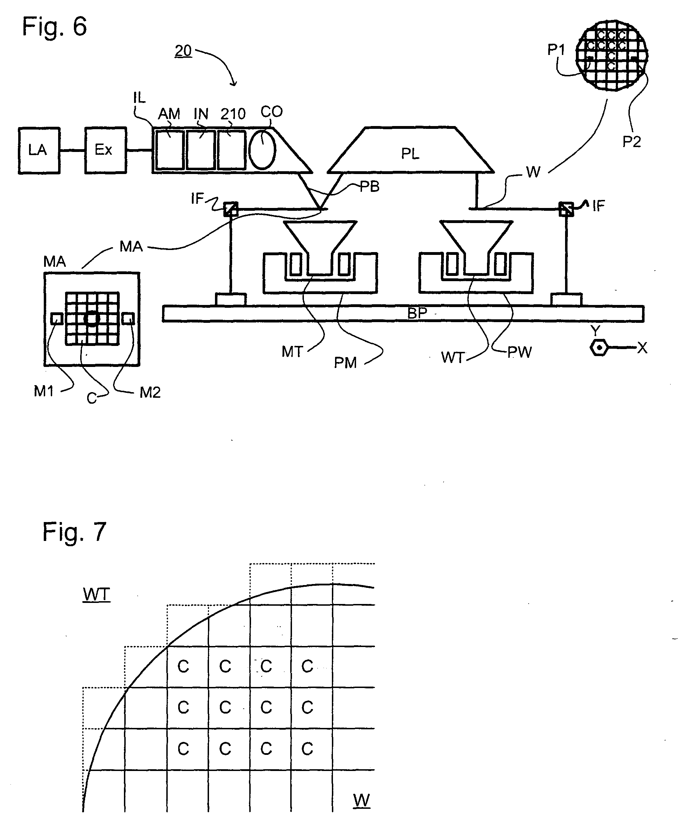

Figure 6 schematically depicts a lithographic projection apparatus 20 according to a second embodiment of the invention. The apparatus comprises:
- a radiation system Ex, IL, for supplying a projection beam PB of radiation (e.g. EUV-radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. projection optics box) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

The lithographic projection apparatus further comprises a beam interceptor 210, as will be explained below. The beam interceptor 210 could be part of the illumination system IL, but could also be positioned at other places along the path of the projection beam in the lithographic projection apparatus.

With reference to Figure 6 it should be noted that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Fig. 7 shows part of a substrate W that is divided in rectangular dies or target portions C. The Figure clearly shows that target portions C on the edge of the substrate W are only partially on the substrate W. Exposing these target portions C will cause exposure energy falling on the object table WT or on the positioning means or the interferometric displacement measuring means, e.g. the measurement mirrors, heating up these parts.

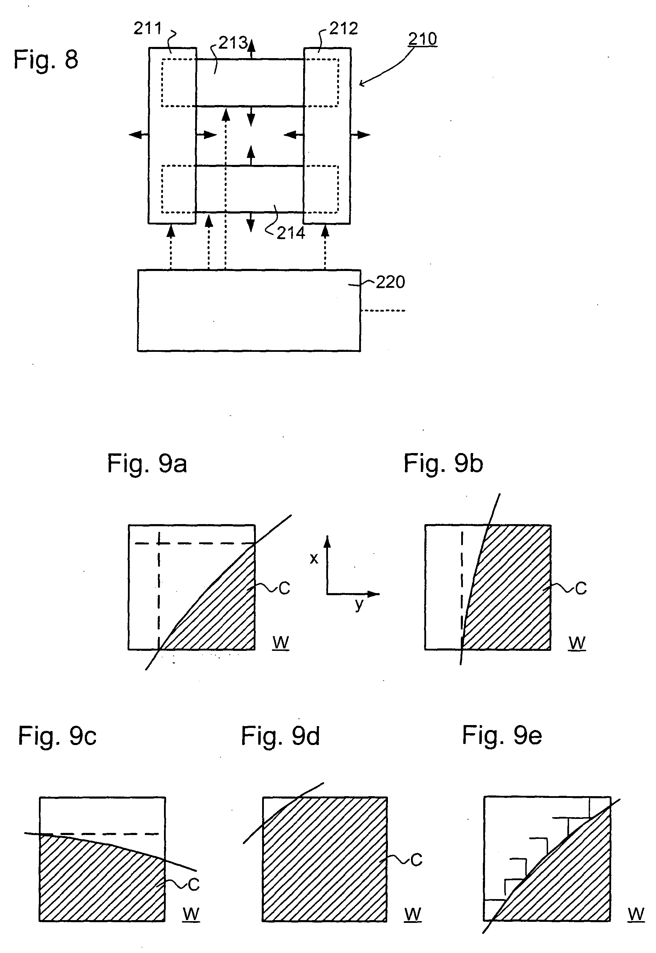

According to an embodiment of the invention, the radiation system Ex, II is provided with a beam interceptor 210, comprising opaque blades 211, 212, 213, 214 that are arranged to intercept part of the projection beam PB, as is shown in Fig. 8. The blades 211, 212, 213, 214 manipulate the size and shape of the exposed projection beam PB on the mask MA and accordingly on the target portions C. These blades 211, 212, 213, 214 are preferably formed by two first blades 211, 212 and two further blades 213, 214, that are substantially perpendicular orientated with respect to the first blades 211, 212. The blades 211, 212, 213, 214 enclose a translucent, substantially rectangular inner area, as is clearly depicted in Fig. 8, and are moveably mounted to the radiation system Ex, II. The first blades 211, 212, can move in a first direction, and the further blades 213, 214 can move in a second direction, substantially perpendicular to the movement of the first blades 211, 212, as indicated by the arrows in Fig. 8.

The movement and positioning of the blades 211, 212, 213, 214 is controlled by a control system 220. The control system 220 is arranged to communicate with a further control system (not shown) controlling the rest of the lithographic projection apparatus in order to receive information about the size of the substrate, the starting position of the projection process, the order in which the subsequent target portions C will be projected etc. Based on this information, the control system 220 can determine if a projected target portion C is fully positioned on the substrate W or not. If not, the control system 220 is arranged to define a new size for this particular target portion C and actuate the beam interceptor 210 accordingly. This will minimize the excess exposure, as will be explained below with reference to Fig. 9. The control system 220 can also be formed as an integral part of a further control system (not shown) controlling the lithographic projection apparatus as a whole. Of course, means need to be provided to move the blades 211, 212, 213, 214. Incorporation of those means is not further explained or showed in the drawings, since these techniques are known, for instance from X-ray technology, and incorporation will therefore be straight forward for a person skilled in the art.

Fig. 9a depicts a part of the edge of a substrate W. The square drawn in fixed lines indicates the dimensions of a target portion C that is only partially on the substrate W. As can be seen, a significant part of the target portion C is located outside the substrate W. In accordance with the invention, the control system 220 will actuate the beam interceptor 210 in such a way that only a smaller square, indicated by the dashed lines, is exposed by the projection beam PB. This can be done by putting the blades corresponding to the upper and left hand edge of the target portion C (with reference to Fig. 9) in such a position that the upper and left hand edge of the projection beam PB correspond to the dashed lines. The blades 211, 212, 213, 214 will be positioned automatically by control system 220 before the projection commences. This will significantly decrease the excessive exposure, as can be seen in Fig. 9a.

Fig. 9b and 9c show other possible situations, wherein only one of the blades 211, 212, 213, 214 can be used to intercept part of the projection beam PB as will readily be understood. The situation depicted in Fig. 9d doesn't allow for intercepting any part of the projection beam at all.

Also other embodiments (not shown) can be envisaged. The beam interceptor 10 can for instance also be provided with further blades, that are positioned in a diagonal position with respect to each other. Also blades could be provided that are not just arranged to move in a certain direction, but are also arranged to rotate. Such embodiments could even further minimize the excessive exposure.

Fig. 9e shows yet an other embodiment according to the present invention. In this embodiment, the projection beam PB is projected in subsequent slides to target portion C. Every slide projects a further part of the target portion C. Between the exposure of every slide, the beam interceptor automatically adjusts the positions of the blades 211, 212, 213, 214. As will readily be understood by a person skilled in the art, only those parts of the target portion C on the left of the dashed lines as indicated in Fig. 9e, will be exposed to the projection beam PB.

Before exposing each target portion C, the control system 220 will determine whether the target portion C is fully positioned on the wafer or not, and if not, the control system 220 will determine which blades need to be put in what position in order to minimize the excessive energy exposure. Finally, the control system 220 will actuate the blades 211, 212, 213, 214 to take the appropriate positions. The control system 220 could be provided with a detection system to detect what target portion C is under the projection beam PB and what the exact position is of the substrate W. However, since the starting position, projection order of the target portions C, dimensions of the substrate W are all known parameters, the control system 220 can also actuate the beam interceptor 210 without using information obtained from such a detection system.

In order to provide a sharp image of the blades 211, 212, 213, 214 on the target portion C, the beam interceptor 210 is preferably positioned in a focal plane of the projection beam PB. This could be in the radiation system Ex, IL as is shown in Fig. 1. However, the blades could also be placed in another focal plane of the projection beam PB, for instance in the lens PL.

The beam interceptor 210 can also be positioned in a position close to the mask MA or the substrate W. In that case, the blades 211, 212, 213, 214 are not exactly in a focal plane of the projection beam PB and are subject to projection blur. Therefore, the blades 211, 212, 213, 214 are not sharply projected on the substrate, due to which wide margins need to be taken into account. However, the blades 211, 212, 213, 214 could still generate a significant decrease of the excessive exposure.

Most lithographic projection apparatus are provided with reticle masking blades, also known as REMA-blades. These REMA-blades are well known to a person skilled in the art and are used to define the size of the part of the target portion C being exposed. Before a sequence of target portions C are exposed, the position of these REMA-blades are adjusted to generate a projection beam PB that corresponds to the size of the target portion C. These REMA-blades are formed in a way that is substantially similar to the beam interceptor 210 described above. Therefore, in a preferred embodiment, the known REMA-blades can be used as a beam interceptor 210.

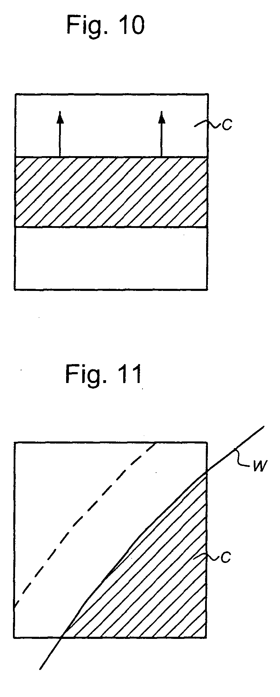

As described above, the target portions C can be exposed in several modes, one of which is the scan mode. In the scan mode, a slit of light is moved over the surface of the target portions C. In order to do that, the REMA-blades need to be actuated in such a way, that not the full target portion C is exposed in a single flash, as is done in the step mode, but only a slit of light is projected. The slit preferably has a rectangular or arcuate shape, of which for instance the width corresponds to the width of the target portion C, and the height is substantially smaller than the height of the target portion C. The projection beam is moved over the surface of the target portion C in order to expose the whole target portion C. This is depicted in Fig. 10, in which the slit is indicated by the diagonal hatching. Moving the projection beam PB over the surface of the target portion C can be done by moving the mask MA and the substrate W accordingly, but can also be done by moving the REMA-blades. In both cases, when the slit reaches the top or bottom part of the target portion C, the horizontal REMA-blades need to be brought closer together in order to avoid exposing of adjacent target portions C, as will readily be understood by a person skilled in the art.

In a preferred embodiment, the position of the blades 211, 212, 213, 214 of the beam interceptor 210, or for instance the REMA-blades, is altered during the scanning process, in such a way that the blades follow the contour of the substrate W. This is explained with reference to Fig. 11. During the movement of the slit over the target portion C, as was explained with reference to Fig. 10, the blade of the beam interceptor 210 corresponding to the left edge of the projection beam PB (according to Fig. 11) can be moved in such a way, that the left edge of the projection beam PB follows the edge of the substrate W. As will be understood by a person skilled in the art, a margin need to be taken into account, as result of the height of the slit. The projection beam PB will follow the dashed line, depicted in Fig. 11. In order to do this, the control system 20 should be arranged to actuate the blades 211, 212, 213, 214 in a dynamic and accurate way. This technique can only be used in a lithographic projection apparatus that uses the scan mode.

While specific embodiments of the invention have been described above, it will be appreciated that the invention may be practiced otherwise than as described. The description is not intended to limit the invention.

## Claims

1. A device manufacturing method comprising:
- providing a substrate;
- providing a projection beam of radiation using an illumination system, the cross-section of said projection beam in an object plane being defined by a beam masking device;
- using patterning means at said object plane to impart the projection beam with a pattern in its cross-section; and
- projecting the patterned beam of radiation onto a target portion of the substrate whilst scanning said substrate in a scan direction; **characterized by**:
- changing the position of an edge of said cross-section of said projection beam in a direction perpendicular to said scanning direction during said projecting step.

2. A method according to claim 1 wherein the position of an edge of the projection beam is changed so as to change the width of the cross-section in the direction (X) perpendicular to the scanning direction (Y) during said projecting step.

3. A method according to claim 2 wherein the area of said substrate exposed during said projecting step is approximately L-shaped.

4. A method according to claim 1, 2 or 3 wherein the area of said substrate exposed during said projecting step has at least one edge extending at an acute angle to said scanning direction.

5. A method according to any one of the preceding claims wherein the patterns exposed in said target portion in an area affected by the change of position of the edge of said cross-section form dummy structures that are not part of a functional device made in the method.

6. A method according to claim 5 wherein said dummy structures are adjacent an alignment mark on said substrate.

7. A method according to claim 5 or 6 wherein said dummy structures are adjacent an edge of said substrate.

8. A device manufactured according to the method of anyone of the preceding claims.

9. A computer program for controlling a lithographic apparatus to manufacture devices, the program comprising program code means that, when executed by the control system of said lithographic apparatus, instruct the lithographic apparatus to:
- provide a projection beam of radiation using an illumination system, the cross-section of said projection beam in an object plane being defined by a beam masking device;
- use patterning means at said object plane to impart the projection beam with a pattern in its cross-section; and
- project the patterned beam of radiation onto a target portion of the substrate whilst scanning said substrate in a scan direction; **characterized by** code means to instruct the apparatus to:
change the position of an edge of said cross-section of said projection beam in a direction perpendicular to said scanning direction during said projecting step.

10. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate whilst the substrate table is scanned in a first direction relative to said projection beam; and
- a beam interceptor that is arranged to intercept a portion of a part of the projection beam that is projected outside the substrate; **characterized by**:
- control means for controlling the beam interceptor to change the position of an edge of said patterned beam in a second direction perpendicular to said first direction whilst said projection beam is projected onto said substrate.

11. A lithographic projection apparatus according to claim 10, wherein said beam interceptor comprises blades that enclose a transparent inner area, the blades being rotatable so as to change the dimensions and shape of the enclosed inner area, to determine what part of the projection beam is intercepted.

12. A lithographic projection apparatus according to claim 10 or 11, wherein said beam interceptor comprises reticle masking blades.
